# EUROPÄISCHE PATENTANMELDUNG

(11) **EP 2 149 913 A1**
(43) Veröffentlichungstag der Anmeldung: **03.02.2010**
(21) Anmeldenummer: 08013784.7
(22) Anmeldetag: 31.07.2008
(51) Int. Cl.: H01L 31/04

(54) **Anlage, insbesondere Photovoltaikanlage**

(71) Anmelder: Siemens Aktiengesellschaft, 80333 München (DE)
(72) Erfinder: Weidauer, Jens, 91315 Höchstadt (DE)

(57) **Zusammenfassung**

Die Erfindung betrifft eine Anlage, insbesondere Photovoltaikanlage mit einer Anzahl montierter Module (M1-M8), wie beispielsweise Photovoltaikmodule. Ein Lichtwellenleiter (L), steht mit einem Sender (S) am einen Ende und einem Empfänger (E) am anderen Ende so mit den Modulen (M1-M8) in Wirkverbindung, dass im Falle einer Demontage eines der Module (M1-M8), der durch den Lichtwellenleiter (L) geführte Lichtstrom unterbrochen wird.

## Beschreibung

Die Erfindung betrifft eine Anlage, insbesondere Photovoltaikanlage gemäß Anspruch 1 sowie ein entsprechendes Modul gemäß Anspruch 6.

Photovoltaikanlagen sind in aller Regel aus einzeln montierten Photovoltaikmodulen aufgebaut, die die von der Sonne empfangene Lichtenergie in elektrische Energie umwandeln. Eine große Anzahl solcher Module werden dann zu großflächigen Anlagen zusammengefasst. Dazu werden die Photovoltaikmodule auf entsprechende Trägersysteme fest montiert. Solche Photovoltaikmodule sind derzeit aber noch hochpreisig und damit stark diebstahlgefährdet. Gerade großflächige Anlagen lassen sich aber nur auf Flächen erstellen, die in der Regel nur eingeschränkt, beispielsweise mittels eines Zaunes geschützt oder mittels Kameras überwacht werden können.

Aufgabe der Erfindung ist es, die Anlage so auszugestalten, dass eine möglichst einfache und kostengünstige und doch sichere Überwachung dieser Anlage möglich ist.

Diese Aufgabe wird dadurch gelöst, dass in einer Anlage, insbesondere einer Photovoltaikanlage, mit einer Anzahl montierter Module, wie beispielsweise Photovoltaikmodule, ein Lichtwellenleiter mit einem Sender an einem Ende und einem Empfänger am anderen Ende so mit den Modulen in Wirkverbindung steht, dass im Falle einer Demontage eines der Module der durch den Lichtwellenleiter geführte Lichtstrom unterbrochen wird. Eine mit dem Empfänger verbundene Kommunikationseinrichtung kann dann ein, vorzugsweise konfigurierbares, Alarmsignal aussenden, wenn der Empfänger nur noch einen Lichtstrom empfängt, der unter einem vorher definierten Schwellwert liegt. Dieser Schwellwert sollte dabei durch den Lichtstrom definiert sein, den der Empfänger noch empfangen würde, wenn es bei der Demontage eines der Module zumindest zu einer teilweisen Zerstörung des Lichtwellenleiters kommt. Eine gewollte Zerstörung bei der Demontage kann vorzugsweise dadurch erreicht werden, dass der Lichtwellenleiter beispielsweise durch Aufkleben unlösbar auf Teilen der Oberfläche der Module aufgebracht ist, so dass eine Demontage eines der Module automatisch auch ein Trennen des Lichtwellenleiters zur Folge hat. Soll die erfindungsgemäße Überwachung mittels Lichtwellenleiter von außen nicht sichtbar sein, kann der Lichtwellenleiter beispielsweise auch in den Stützrohren des Trägersystems zu den Modulen geführt werden. Bei einer Demontage der Module von diesen Stützrohren würde dann wiederum der Lichtwellenleiter unterbrochen werden.

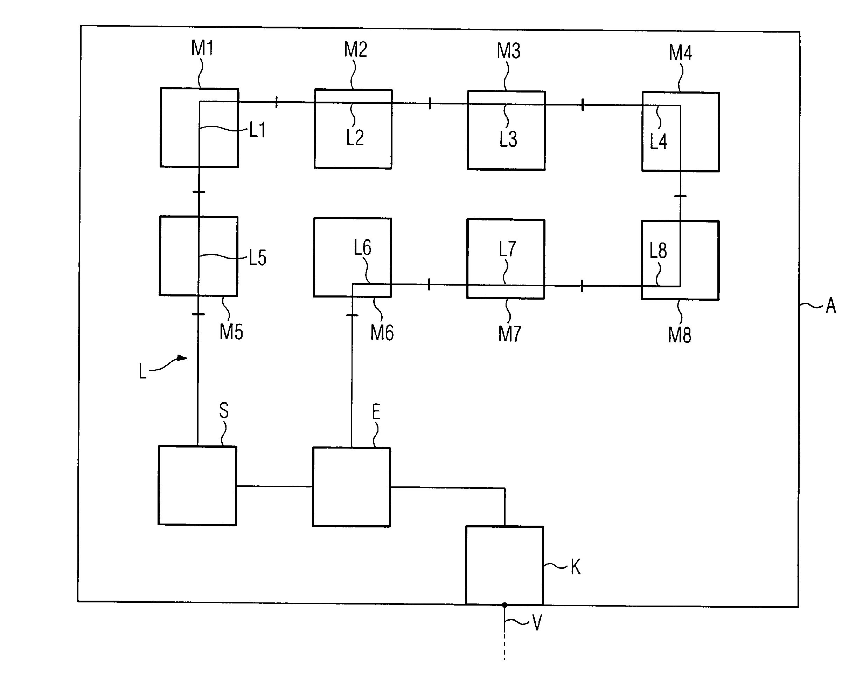

Anhand der Figur soll nun exemplarisch die Erfindung beschrieben werden. Die Figur zeigt schematisch eine Photovoltaikanlage A mit acht Photovoltaikmodulen M1 bis M8. Ein Lichtwellenleiter L mit acht Teilstücken L1 bis L8 ist auf der einen Seite mit einem Sender und auf der anderen Seite mit einem Empfänger verbunden. Der Sender S, vorzugsweise eine Laserdiode, koppelt Licht mit einem definierten Lichtstrom in den Lichtwellenleiter L ein. Aufgrund der geringen Übertragungsverluste im Lichtwelleleiter L wird dieser Lichtstrom in nahezu gleicher Größe vom Empfänger E am anderen Ende des Lichtwellenleiters L empfangen. Vorzugsweise sind die einzelnen Teilsegmente L1 bis L8 des Lichtwellenleiters L nichtlösbar und flächig auf die Oberflächen der einzelnen Module M1 bis M8 aufgebracht. Zwischen den Modulen M1 bis M8 muss der Lichtwellenleiter L und dessen Teilstücke L1 bis L8 so geführt oder angebracht sein, dass im Falle der Demontage die Verbindung zwischen den Teilstücken oder ein Teilstück selbst zerstört oder unterbrochen wird. Dadurch wird an dieser Stelle der Lichtstrom durch den Lichtwellenleiter L unterbrochen. Beim Empfänger E kommt dann entweder ein deutlich geringerer oder gar kein Lichtstrom mehr an. Eine mit dem Empfänger E und ggf. auch dem Sender S verbundene Auswerteeinrichtung erkennt dann, dass der empfangene Lichtstrom unter einem definierten Lichtstromschwellwert liegt und kann somit über eine Kommunikationseinrichtung K eine Alarmmeldung über eine Verbindungseinrichtung V aussenden. Je nach Standort und Infrastruktur der Anlage kann diese Verbindungseinrichtung ein drahtgebundenes oder auch drahtlos sein über die das Alarmsignal an einen Kommunikationspartner, wie zum Beispiel einen Webserver, gesendet wird. Dieser Kommunikationspartner kann dann diese Alarmmeldung beispielsweise in Form einer SMS, eines Fax oder einer Email an die zu informierenden Stellen weiterleiten.

## Patentansprüche

1. Anlage (A), insbesondere Photovoltaikanlage, mit einer Anzahl montierter Module (M1-M8), wie beispielsweise Photovoltaikmodule,
**dadurch gekennzeichnet, dass**
ein Lichtwellenleiter (L) mit einem Sender (S) am einen Ende und einem Empfänger (E) am anderen Ende so mit den Modulen (M1-M8) in Wirkverbindung steht, dass im Falle einer Demontage eines der Module (M1-M8) der durch den Lichtwellenleiter (L) geführte Lichtstrom unterbrochen wird.

2. Anlage nach Anspruch 1,
**dadurch gekennzeichnet, dass**
eine mit dem Empfänger (E) verbundene Kommunikationseinrichtung (K) über eine Verbindungseinrichtung (V) ein Alarmsignal aussendet, wenn der Empfänger (E) einen Lichtstrom unter einem Schwellwert empfängt.

3. Anlage nach Anspruch 1 oder 2,
**dadurch gekennzeichnet, dass**
das Alarmsignal vom Betreiber der Anlage (A) konfigurierbar ist.

4. Anlage nach einem der Ansprüche 1 bis 3,
**dadurch gekennzeichnet, dass**
der Lichtwellenleiter (L) unlösbar auf die Oberfläche der Module aufgebracht ist.

5. Anlage nach einem der Ansprüche 1 bis 4,
**dadurch gekennzeichnet, dass**
der Lichtwellenleiter (L) zumindest in Teilen der Modulen oder deren Montagehalterungen von außen nicht sichtbar geführt ist.

6. Modul (M1-M8), insbesondere montierbares Photovoltaikmodul, mit einem Lichtwellenleiterteilstück (L1-L8) das unlösbar mit weiteren Lichtwellenleiterteilstücken (L1-L8) weiterer montierter Modulen (M1-M8) verbindbar ist, wobei das Lichtwellenleiterteilstück (L1-L8) so mit dem Modul (M1-M8) in Wirkverbindung steht, dass im Falle einer Demontage des Moduls (M1-M8) der durch den Lichtwellenleiter (L) geführte Lichtstrom unterbrochen wird.
